# EUROPEAN PATENT APPLICATION

(11) **EP 1 471 748 A1**
(43) Date of publication of application: **27.10.2004**
(21) Application number: 04101614.8
(22) Date of filing: 19.04.2004
(51) Int. Cl.: H04Q 1/02, H05K 7/20, H05K 7/14

(54) **Integrated utility cabinet for a telecommunication exchange**

(30) Priority: 18.04.2003 IT BO20030046 U
(71) Applicant: Azerre S.A., 1724 Luxembourg (LU)
(72) Inventor: Ninno, Gianluca, 2163 Luxembourg (LU)
(74) Representative: Jorio, Paolo

(57) **Abstract**

An integrated utility cabinet (6) for a telecommunication exchange (1); the cabinet (6) is parallelepiped-shaped, and houses an air conditioning system (7) for air conditioning an interior (3) of the telecommunication exchange (1), and a power station (8) for electrically powering the air conditioning system (7), the telecommunication devices (5) of the telecommunication exchange (1), and the utilities (9) of the telecommunication exchange (1).

## Description

The present invention relates to an integrated utility cabinet for a telecommunication exchange.

The present invention may be used to advantage in the mobile telephone sector, to which the following description refers purely by way of example.

A mobile telephone telecommunication exchange comprises a housing normally defined by a metal container, which can be transported by truck, and has a door permitting access inside by exchange maintenance and/or inspection personnel. The container houses a number of cabinets, each housing a respective telecommunication device; a cabinet housing an air conditioning system for air conditioning the interior of the container; and one or more cabinets housing a power station for electrically powering the air conditioning system, telecommunication devices, and any utilities.

To cope with the increasing use of mobile telephones and, above all, the introduction of new communication standards (e.g. UMTS) alongside existing ones, mobile telephone telecommunication exchanges must be continually expanded to accommodate an increasing amount of telecommunication equipment. This means frequently replacing existing containers at the exchange with larger ones, which involves fairly considerable cost and relatively prolonged shutdown of the exchange.

It is an object of the present invention to provide an integrated utility cabinet for a telecommunication exchange, designed to eliminate the aforementioned drawbacks, and which, in particular, is cheap and easy to produce.

According to the present invention, there is provided an integrated utility cabinet for a telecommunication exchange, as claimed in Claim 1 and, preferably, in any one of the following Claims depending directly or indirectly on Claim 1.

A number of non-limiting embodiments of the present invention will be described by way of example with reference to the accompanying drawings, in which:
Figure 1 shows a schematic, horizontally sectioned plan view of a telecommunication exchange featuring the integrated cabinet according to the present invention;
Figure 2 shows a schematic, horizontally sectioned plan view of a further embodiment of a telecommunication exchange featuring the integrated cabinet according to the present invention;
Figure 3 shows a front view in perspective of the integrated cabinet in Figures 1 and 2;
Figure 4 shows a rear view in perspective of the integrated cabinet in Figures 1 and 2;
Figure 5 shows a front view in perspective of the integrated cabinet in Figures 1 and 2, with a number of protective panels removed to expose part of the interior of the cabinet;
Figure 6 shows a schematic, horizontally sectioned plan view of a bottom portion of the integrated cabinet in Figures 1 and 2;
Figure 7 shows a schematic, horizontally sectioned plan view of a bottom portion of an alternative embodiment of the integrated cabinet in Figures 1 and 2;
Figure 8 shows an operating diagram of the components inside the integrated cabinet in Figures 1 and 2.

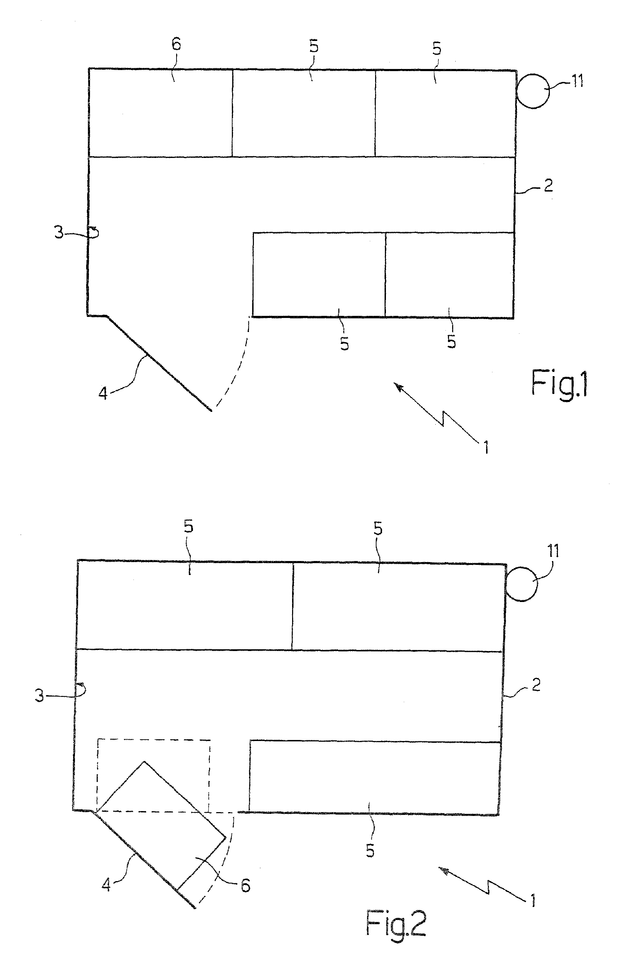

Number 1 in Figure 1 indicates as a whole a telecommunication exchange comprising a parallelepiped-shaped metal container 2 having an interior 3 accessible from the outside by means of a hinged door 4. Metal container 2 houses a number of telecommunication devices 5, and a utility cabinet 6 in turn housing an air conditioning system 7 for air conditioning interior 3 of telecommunication exchange 1; a power station 8 for electrically powering air conditioning system 7, telecommunication devices 5 and the utilities 9 of telecommunication exchange 1; and a control unit 10 for controlling power station 8 and air conditioning system 7. A pole 11 is fixed to the outside of metal container 2, and supports a number of radiating antennas (not shown) connected to telecommunication devices 5.

As shown in Figure 1, utility cabinet 6 is fixed to an inner wall of container 2 by respective fastening means (not shown). In an alternative embodiment shown in Figure 2, utility cabinet 6 is fixed to hinged door 4 by respective fastening means (not shown); which solution, for a given volume of interior 3, increases the space available for telecommunication devices 5.

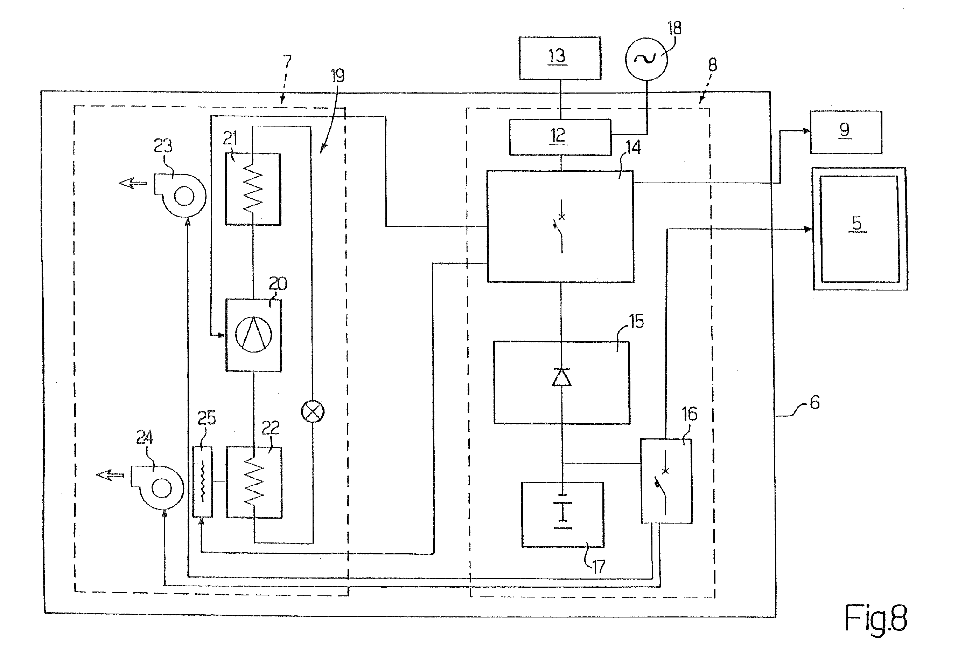

As shown in Figure 8, power station 8 comprises an input section 12 supplied with alternating electric current by an external electric line 13; an alternating current distribution section 14 supplied by input section 12; a conversion section 15 supplied by alternating current distribution section 14 and generating direct electric current; a direct current distribution section 16 supplied by conversion section 15 and for supplying telecommunication devices 5; and a buffer battery system 17 connected to direct current distribution section 16. The utilities 9 of telecommunication exchange 1 (typically lighting and power take-offs) are supplied with alternating electric current by alternating current distribution section 14. Input section 12 preferably comprises a lighting arrester (not shown), and an socket (not shown) for an external generator set 18.

Air conditioning system 7 preferably circulates air inside interior 3 of telecommunication exchange 1 by dislocation, i.e. a system whereby conditioned air is fed into the bottom of interior 3 at relatively low speed (typically less than 1 m/sec). Air conditioning system 7 comprises a cooling circuit 19, in turn comprising a compressor 20 supplied with alternating current by alternating current distribution section 14, a heat exchanger 21 for exchanging heat with the outside environment, and a heat exchanger 22 for exchanging heat with interior 3 of telecommunication exchange 1. Heat exchanger 21 is connected to a condenser of cooling circuit 19, and has a ventilation device 23 for forced air circulation to the outside and supplied with direct current by direct current distribution section 16; and heat exchanger 22 is connected to an evaporator of cooling circuit 19, and has a ventilation device 24 for forced air circulation into interior 3 of telecommunication exchange 1 and supplied with direct current by direct current distribution section 16.

In a preferred embodiment, air conditioning system 7 comprises an electric resistor 25, which is connected to ventilation device 24, provides for heating the air circulating in interior 3 of telecommunication exchange 1, and is supplied with alternating current by alternating current distribution section 14.

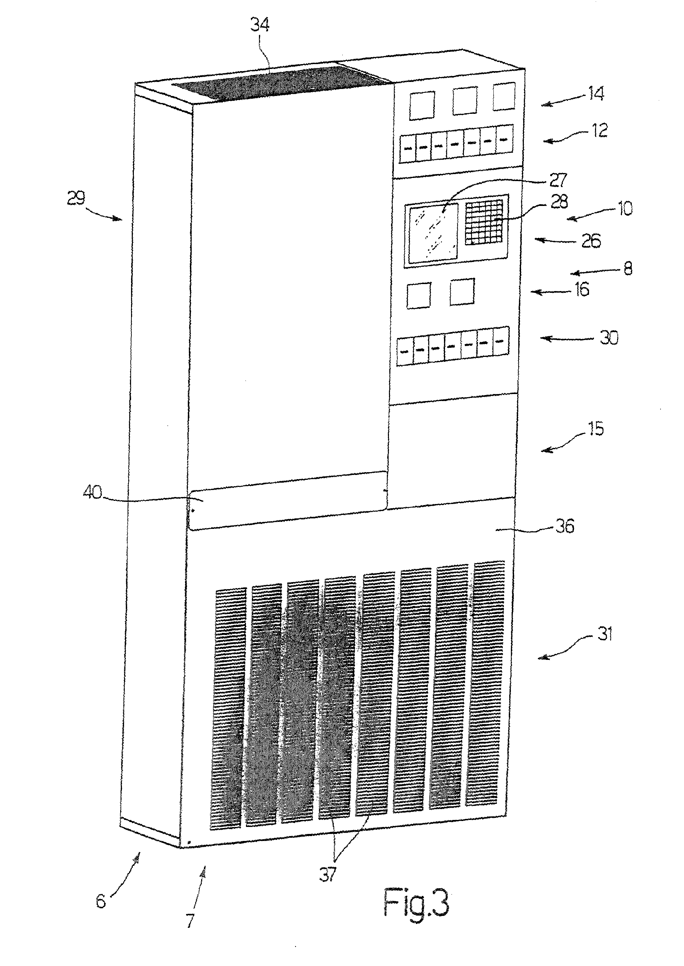

As shown in Figure 3, control unit 10 comprises a user interface device 26 having a screen 27 and a keyboard 28. In a preferred embodiment, control unit 10 comprises one controller (not shown) connected to user interface device 26 to control both power station 8 and air conditioning system 7. In an alternative embodiment, control unit 10 comprises a first controller (not shown) connected to user interface device 26 to control power station 8; and a second controller (not shown) connected to user interface device 26 to control air conditioning system 7.

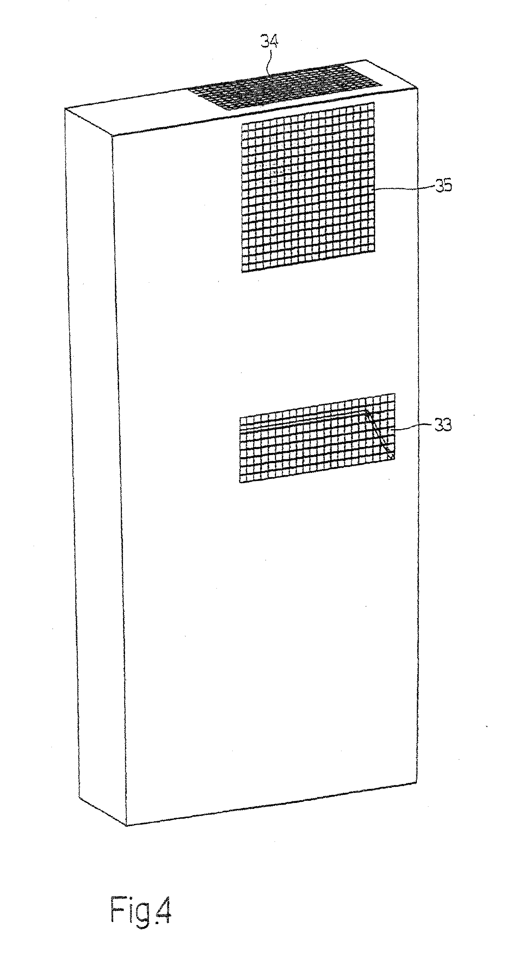

As shown in Figures 3, 4 and 5, the interior of cabinet 6 is divided into three areas 29, 30 and 31; area 29 is located in a top left portion of cabinet 6, and houses heat exchanger 21; area 30 is located in a top right portion of cabinet 6, alongside area 29, and houses input section 12, alternating current distribution section 14, conversion section 15, and direct current distribution section 16; and area 31 is located in a bottom portion of cabinet 6, and houses heat exchanger 22 and buffer battery system 17.

A system 32 of powered shutters is located between areas 29 and 31, is supplied with direct current by direct current distribution section 16, and determines whether the air conducted by ventilation device 24 comes from outside through an air inlet 33, or from interior 3 of telecommunication exchange 1 through an air inlet 34 in a top portion of cabinet 6. A grille 35 is also provided, through which the air conducted by ventilation device 23 is expelled to the outside.

Area 31 is closed by a panel 36 having a grille 37, which extends substantially the whole width of panel 36 and permits air flow from inside cabinet 6 into interior 3 of telecommunication exchange 1.

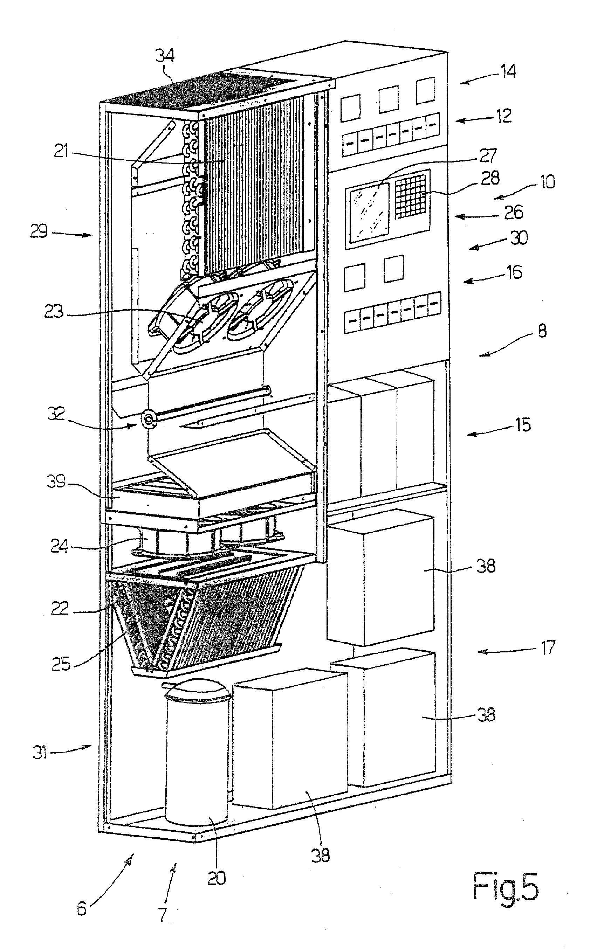

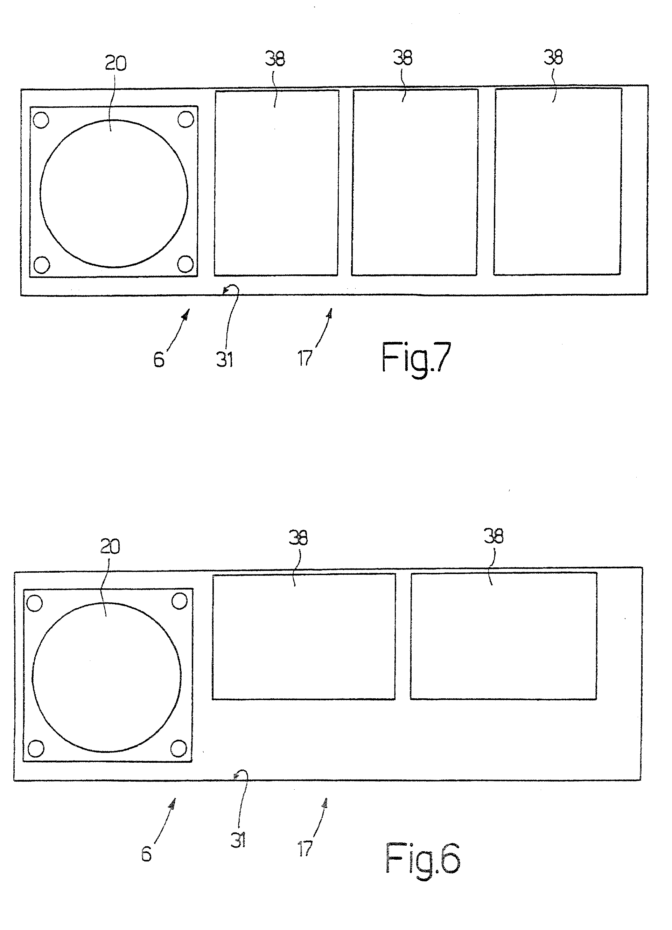

Area 31 is preferably provided with baffle panels (not shown for the sake of clarity), which direct the air from ventilation device 24 towards grille 37, and at least partly shield battery system 17 and compressor 20 from the air from ventilation device 24. In area 31, compressor 20 and the accumulators 38 of battery system 17 are detached from an inner wall of panel 36 provided with grille 37, so as to permit free flow of the air from ventilation device 24 to grille 37. Figures 5 and 6 show a preferred arrangement, and Figure 7 an alternative arrangement, of accumulators 38 in area 31.

In normal operating conditions, i.e. with external electric line 13 or generator set 18 working, air conditioning system 7 may use compressor 20 (supplied with alternating current) to cool the air from ventilation device 24 (supplied with direct current), or electric resistor 25 (supplied with alternating current) to heat the air from ventilation device 24. In emergency operating conditions, i.e. with external electric line 13 cut off and generator set 18 not working, air conditioning system 7 can only use ventilation device 24 (supplied with direct current) to force-circulate air into interior 3 of telecommunication exchange 1 in so-called "free-cooling" mode.

A filter 39 is preferably provided upstream from ventilation device 24, and can be removed quickly from cabinet 6 through an opening closed by a cover 40.

Cabinet 6 is therefore relatively compact and houses all the utilities of telecommunication exchange 1, so that container 2 only houses cabinet 6 and telecommunication devices 5. Using cabinet 6 increases the space available for telecommunication devices in both existing and future telecommunication exchanges 1. That is, the power station cabinet and air conditioning cabinet of an existing telecommunication exchange 1 may be replaced with cabinet 6 to make room for additional telecommunication devices.

## Claims

1. An integrated utility cabinet (6) for a telecommunication exchange (1) comprising a number of telecommunication devices (5); the cabinet (6) housing an air conditioning system (7) for air conditioning an interior (3) of the telecommunication exchange (1); and the cabinet (6) being **characterized by** housing a power station (8) for electrically powering the air conditioning system (7) and the telecommunication devices (5) of the telecommunication exchange (1), and a control unit (10) for controlling both the power station (8) and the air conditioning system (7).

2. A cabinet (6) as claimed in Claim 1, wherein the power station (8) comprises an input section (12) supplied with alternating electric current by an external electric line (13); an alternating current distribution section (14) supplied by the input section (12); a conversion section (15) supplied by the alternating current distribution section (14) and generating direct electric current; a direct current distribution section (16) supplied by the conversion section (15) and supplying the telecommunication devices (5); and a buffer battery system (17) connected to the direct current distribution section (16).

3. A cabinet (6) as claimed in Claim 2, wherein the input section (12) comprises a lightning arrester.

4. A cabinet (6) as claimed in Claim 2 or 3, wherein the input section (12) comprises an socket for a generator set (18).

5. A cabinet (6) as claimed in Claim 2, 3 or 4, wherein the air conditioning system (7) comprises a cooling circuit (19) having a compressor (20) supplied with alternating current by the alternating current distribution section (14), a first heat exchanger (21) for exchanging heat with the outside environment, and a second heat exchanger (22) for exchanging heat with the interior (3) of the telecommunication exchange (1) ; the first heat exchanger (21) having a first ventilation device (23) for forced air circulation to the outside environment; and the second heat exchanger (22) having a second ventilation device (24) supplied with direct current by the direct current distribution section (16) and for forced air circulation into the telecommunication exchange (1).

6. A cabinet (6) as claimed in Claim 5, wherein the air conditioning system (7) comprises an electric resistor (25) which is connected to the second ventilation device (24), heats the air circulating inside the telecommunication exchange (1), and is supplied with alternating current by the alternating current distribution section (14).

7. A cabinet (6) as claimed in Claim 5 or 6, wherein the air conditioning system (7) comprises a system (32) of powered shutters, which is supplied with direct current by the direct current distribution section (16) and determines whether the air from the second ventilation device (24) comes from the outside through a first air inlet (33), or comes from the interior (3) of the telecommunication exchange (1) through a second air inlet (34) in a top portion of the cabinet (6).

8. A cabinet (6) as claimed in Claim 5, 6 or 7, wherein an interior (3) of the cabinet (6) is divided into three areas (29, 30, 31), of which a first area (29) is located in a top portion of the cabinet (6), a second area (30) is located in a top portion of the cabinet (6) alongside the first area (29), and a third area (31) is located in a bottom portion of the cabinet (6); the first area (29) housing the first heat exchanger (21); the third area (31) housing the second heat exchanger (22) and the buffer battery system (17); and the second area (30) housing the input section (12), the alternating current distribution section (14), the conversion section (15), and the direct current distribution section (16).

9. A cabinet (6) as claimed in Claim 8, wherein the third area (31) is closed by a cover panel (36) having a grille (37), which permits air flow from inside the cabinet (6) into the interior of the telecommunication exchange (1), and which extends substantially the whole width of the cover panel (36).

10. A cabinet (6) as claimed in Claim 9, wherein the third area (31) is provided with baffle panels for directing the air from the second ventilation device (24) to the grille (37).

11. A cabinet (6) as claimed in Claim 10, wherein the baffle panels of the third area (31) at least partly shield the buffer battery system (17) from the air from the second ventilation device (24).

12. A cabinet (6) as claimed in Claim 10, wherein the baffle panels of the third area (31) at least partly shield the compressor (20) from the air from the second ventilation device (24).

13. A cabinet (6) as claimed in one of Claims 9 to 12, wherein the buffer battery system (17) comprises a number of accumulators (38) which are detached from an inner wall of the cover panel (36) having the grille (37).

14. A cabinet (6) as claimed in one of Claims 1 to 13, wherein the air conditioning system (7) circulates air into the interior (3) of the telecommunication exchange (1) by means of a dislocation system.

15. A cabinet (6) as claimed in one of Claims 1 to 14, wherein the control unit (10) comprises a user interface device (26); and one controller connected to the user interface device (26) to control both the power station (8) and the air conditioning system (7).

16. A cabinet (6) as claimed in one of Claims 1 to 14, wherein the control unit (10) comprises a user interface device (26); a first controller connected to the user interface device (26) to control the power station (8); and a second controller connected to the user interface device (26) to control the air conditioning system (7).

17. A cabinet (6) as claimed in one of Claims 1 to 16, and comprising fastening means for fixing the cabinet (6) to an inner wall of a container (2) housing the telecommunication exchange (1).

18. A cabinet (6) as claimed in one of Claims 1 to 16, and comprising fastening means for fixing the cabinet (6) to a hinged door (4) of a container (2) housing the telecommunication exchange (1).

19. A container (2) for a telephone exchange (1); the container (2) housing a number of telecommunication devices (5), and comprising an integrated utility cabinet (6) as claimed in Claims 1 to 18.

20. A container (2) as claimed in Claim 19, and comprising a hinged door (4); the integrated utility cabinet (6) being fixed to the hinged door (4).

21. A telephone exchange (1) comprising a container (2) housing a number of telecommunication devices (5) and an integrated utility cabinet (6) as claimed in Claims 1 to 18.
